# EUROPEAN PATENT APPLICATION

(11) **EP 4 852 705 A1**
(43) Date of publication of application: **09.12.2026**
(21) Application number: 26180412.4
(22) Date of filing: 21.05.2026
(51) Int. Cl.: H10W 90/10, H10W 42/00, H10W 40/25, H10W 76/138

(54) **POWER MODULE, POWER CONVERSION DEVICE, AND ELECTRIC VEHICLE**

(30) Priority: 04.06.2025 CN 202510735786
(71) Applicant: HUAWEI TECHNOLOGIES CO., LTD., Shenzhen 518129 (CN)
(72) Inventor: ZHOU, Yu, Shenzhen, 518129 (CN); QIAN, Qiuxiao, Shenzhen, 518129 (CN); ZHENG, Sheng, Shenzhen, 518129 (CN); LV, Zhen, Shenzhen, 518129 (CN); LV, Yafei, Shenzhen, 518129 (CN)
(74) Representative: Gill Jennings & Every LLP

(57) **Abstract**

This application relates to the field of power electronics technologies, and in particular, to a power module, a power conversion device, and an electric vehicle. The power module includes a bottom plate and a plurality of power chips. The bottom plate includes an insulation bottom plate, a first metal layer, a plurality of signal pads, and a plurality of routing layers. The plurality of power chips are disposed on the first metal layer and the plurality of power chips and the plurality of signal pads are spaced from each other in a first direction. A gate signal electrode of each power chip is connected to one signal pad or one routing layer, and a power signal electrode of each power chip is connected to one signal pad or one routing layer. A first end of each routing layer is connected to one signal pad, and a second end extends to be arranged, in a second direction, between an edge of the first metal layer and an edge of the insulation bottom plate. Widths of the plurality of routing layers are less than a width of the first metal layer. Thus, a structure layout of the power module can be optimized, to help improve heat dissipation and reliability of the power module.

## Description

### TECHNICAL FIELD

This application relates to the field of power electronics technologies, and in particular, to a power module, a power conversion device, and an electric vehicle.

### BACKGROUND

A power module is a core component in a power electronic device, and implements conversion and management of electric energy by integrating one or more power semiconductor devices. Therefore, power modules are widely used in fields such as photovoltaics, energy storage, and electric vehicles.

In a power module in the conventional technology, a plurality of power chips are disposed on a bottom plate, and different power chips implement circuit routing via a substrate. For a power module having a large-sized power chip, different circuit routing designs of the power chip affect reliability of the device.

### SUMMARY

This application provides a power module, a power conversion device, and an electric vehicle. The power module can simplify circuit routing of the module, optimize a structure layout of the power module, and help improve reliability of the power module.

According to a first aspect, this application provides a power module. The power module includes a bottom plate and a plurality of power chips. The bottom plate includes an insulation bottom plate, a first metal layer, a plurality of signal pads, and a plurality of routing layers. The plurality of power chips are disposed on the first metal layer. The plurality of power chips and the plurality of signal pads are spaced from each other in a first direction. A surface that is of each power chip and that faces away from the first metal layer is connected to a top plate via one or more connection blocks, a gate signal electrode of each power chip is connected to one signal pad or one routing layer, and the signal pad is configured to connect to a signal terminal. A first end of each routing layer is connected to one signal pad, and a second end extends to be arranged, in a second direction, between an edge of the first metal layer and an edge of the insulation bottom plate. In the second direction, widths of the plurality of routing layers are less than a width of the first metal layer. Both the first direction and the second direction are perpendicular to a thickness direction of the power module, and the first direction is perpendicular to the second direction.

In the foregoing power module, a signal electrode of a power chip that is in the plurality of power chips and that is close to the signal pad may be directly connected to the signal pad, and a signal electrode of a power chip that is far away from the signal pad may be connected to a nearby routing layer, to implement a circuit connection to the signal pad through the routing layer, and simplify the circuit connection and a structure layout of the module. Each routing layer is at least partially arranged between the first metal layer and the edge of the insulation bottom plate in the second direction, so that force balance of the insulation bottom plate can be improved, and a risk of fracture or warping of the insulation bottom plate can be reduced, thereby improving structural reliability of the module.

In an embodiment, the plurality of power chips include a first chip and a second chip, and the first chip is arranged between and spaced from the plurality of signal pads and the second chip in the first direction. A power signal electrode of the first chip is connected to one signal pad, a gate signal electrode of the first chip is connected to another signal pad, a power signal electrode of the second chip is connected to one routing layer, and a gate signal electrode of the second chip is connected to another routing layer. This avoids a case in which a direct wire connection between the second chip and the plurality of signal pads needs to cross the first chip, reduces a short-circuit risk, and improves circuit connection reliability.

In an embodiment, the first chip and the second chip are connected in parallel, the one signal pad connected to the power signal electrode of the first chip is connected to the one routing layer connected to the power signal electrode of the second chip, and the another signal pad connected to the gate signal electrode of the first chip is connected to the another routing layer connected to the gate signal electrode of the second chip. The power signal electrodes of the first chip and the second chip share one signal pad, and the gate signal electrodes of the first chip and the second chip share another signal pad.

In an embodiment, the plurality of routing layers include a first routing layer and a second routing layer. In the second direction, a part of the first routing layer and a part of the second routing layer are adjacently arranged between the first chip and the edge of the insulation bottom plate, and the part of the first routing layer is arranged between the first chip and the part of the second routing layer. The first routing layer and the second routing layer are arranged on a same side of the second chip, to facilitate routing connection of the second chip.

In an embodiment, in the second direction, the power signal electrode of the second chip is arranged between the gate signal electrode of the second chip and the first routing layer, the power signal electrode of the second chip is connected to the second routing layer, and the gate signal electrode of the second chip is connected to the first routing layer. A connection between the power signal electrode of the second chip and the second routing layer can avoid a connection between the gate signal electrode of the second chip and the first routing layer, to further optimize a structure layout of the module.

In an embodiment, in the first direction, a connection position between the gate signal electrode of the second chip and the first routing layer is located between the first chip and the second chip, and a connection position between the power signal electrode of the second chip and the second routing layer is located between the first chip and the second chip. In this way, the second chip implements a signal circuit connection through the routing layer.

In an embodiment, the connection position between the power signal electrode of the second chip and the second routing layer is located on a side that is of the connection position between the gate signal electrode of the second chip and the first routing layer and that is away from the plurality of signal pads, to avoid a short-circuit risk caused by routing crossover.

In an embodiment, the plurality of routing layers include a first routing layer and a second routing layer. In the first direction, a length of the first routing layer is greater than a length of the second routing layer. The first routing layer and the second routing layer are arranged in different lengths, so that the connection position between the first routing layer and the gate signal electrode of the second chip and the connection position between the second routing layer and the power signal electrode of the second chip can be arranged in a staggered manner in the first direction. This helps optimize a circuit routing layout and avoid a short circuit.

In an embodiment, in the first direction, a spacing between the first routing layer and an end that is of the insulation bottom plate and that is away from the plurality of signal pads is less than a spacing between the second chip and the end that is of the insulation bottom plate and that is away from the plurality of signal pads, so that internal stress of the insulation bottom plate can be further uniform, and structural reliability of the bottom plate and the module can be improved.

In an embodiment, a spacing between the second routing layer and the end that is of the insulation bottom plate and that is away from the plurality of signal pads is less than a spacing between the first chip and an end that is of the insulation bottom plate and that is away from the plurality of signal pads. The second routing layer may meet a nearby circuit connection of the power signal electrode of the second chip. In an embodiment, the plurality of power chips include two groups of chips, one group of chips and the other group of chips are spaced from each other in the second direction, and each group of chips includes a first chip and a second chip. The plurality of routing layers include two groups of routing layers, and each group of routing layers includes a first routing layer and a second routing layer. The two groups of routing layers are respectively arranged on two sides of the first metal layer in the second direction, a power signal electrode of the second chip in each group of chips is connected to a second routing layer in an adjacent group of routing layers, and a gate signal electrode of the second chip in each group of chips is connected to a first routing layer in an adjacent group of routing layers. The two groups of chips are respectively connected to the signal pad through one group of routing layers, to improve force balance of the bottom plate in the second direction.

In an embodiment, the power module further includes a plurality of diodes, the plurality of diodes are disposed between the two groups of chips in the second direction, and each diode is connected in parallel to one power chip. The power chip is closer to the edge of the insulation bottom plate than the diode. This facilitates signal electrode routing of the power chip, and can also reduce a risk of warping at the edge of the bottom plate.

In an embodiment, the plurality of diodes include two groups of diodes, one group of diodes and the other group of diodes are spaced from each other in the second direction, and one group of diodes is staggered relative to the other group of diodes in the first direction. Each diode in one group of diodes is configured to be connected in parallel to one power chip in one group of chips, and each diode in the other group of diodes is configured to be connected in parallel to one power chip in the other group of chips. Idle space of the two groups of diodes may be used for layout of another structure, and no larger space of the bottom plate is occupied. This facilitates implementation of miniaturization of the module.

In an embodiment, the power module further includes the top plate and the plurality of connection blocks. In a direction perpendicular to the bottom plate, the top plate is disposed on a side that is of the plurality of power chips and that faces away from the bottom plate. Each power chip further includes a second electrode. Both the second electrode and the signal electrodes are disposed on a surface that is of the power chip and that faces the top plate, a surface that is of the second electrode and that faces away from the bottom plate is connected to the connection block, and the signal electrodes are spaced from each other in the first direction on a side that is of the second electrode and that faces the signal pad. This facilitates a connection between the signal electrode of the power chip and the signal pad, and reduces a routing distance.

In an embodiment, in the direction perpendicular to the thickness direction of the power module, the connection block does not protrude from an edge of the power electrode, and a distance between the connection block and the edge of the second electrode is 0.2 mm to 0.5 mm. The connection block can be in contact with the second electrode of the power chip in a large range, to ensure high efficiency of a heat transfer channel. In addition, improving balance of temperature and stress distribution of the power chip can reduce a risk of a crack or a fracture of the power chip, and improve stability of the module, so that the power module has good performance in reliability assessment.

In an embodiment, in the thickness direction of the power module, an orthographic projection of the connection block, on the power chip, falls within a range of an active region of the power chip. In the direction perpendicular to the thickness direction of the power module, a distance between an edge of the active region of the power chip and an edge of the connection block is less than or equal to 0.5 mm, to enhance heat conduction effect, and further balance temperature distribution and stress distribution in the power chip.

In an embodiment, each power chip includes a gate signal electrode and at least two power signal electrodes, and the at least one power signal electrode is arranged between and spaced from the gate signal electrode and one routing layer in the second direction and is connected to one routing layer, so that a routing path can be reduced, connection reliability can be improved, and the module space layout can be optimized.

In an embodiment, each routing layer and a connected signal pad have an integrated structure. During specific fabrication, the first metal layer may be formed at a same layer, and the routing layer and the signal pad are formed in a manner like etching.

In an embodiment, in the direction perpendicular to the thickness direction of the power module, a distance between each power chip and the edge of the insulation bottom plate is greater than or equal to 3 mm. There is a sufficient spacing between the power chip and the edge of the insulation bottom plate, to prevent the power chip from causing a large mechanical stress change of the insulation bottom plate. There is a sufficient spacing between the power chip and the edge of the insulation bottom plate. When a heat change in a switching process of the power chip is transferred to the insulation bottom plate, the insulation bottom plate has a sufficiently large region for heat to be evenly distributed, to improve temperature distribution balance of the insulation bottom plate, and reduce a risk of excessive stress concentration. Improving temperature and stress distribution balance of the insulation bottom plate can reduce a risk of warping, a crack, or a fracture of the insulation bottom plate, and improve insulation and stability of the module, so that the power module has good performance in reliability assessment.

In an embodiment, each diode includes an anode, and the anode is disposed on a surface that is of the diode and that faces the top plate and is connected to the connection block. In the direction perpendicular to the thickness direction of the power module, the connection block does not protrude from an edge of the anode, and a distance between the connection block and the edge of the anode is 0.2 mm to 0.5 mm. The connection block can be in contact with the anode of the diode in a large range, to ensure high efficiency of a heat transfer channel. A spacing between the connection block and the edge of the anode can ensure that force transferred by the connection block to the diode does not increase stress generated inside the diode. Improving temperature and stress distribution balance of the diode can reduce a risk of a crack or a fracture of the diode, and improve stability of the module, so that the power module has good performance in reliability assessment.

In an embodiment, the first metal layer includes an input side and an output side, and the input side and the output side are opposite to each other in a first direction. In the second direction, a length of the input side is greater than a length of the output side, each signal pad and the output side are spaced from each other, and the second direction is perpendicular to the thickness direction of the power module and the first direction, to save layout space.

According to a second aspect, this application provides a power conversion device. The power conversion device includes at least one power module according to any one of the first aspect, and each power module is configured to convert a direct current into an alternating current or convert an alternating current into a direct current. The at least one power module may be integrated on one circuit board or heat sink in a parallel manner. Because the power module is easier to implement miniaturization and has higher reliability, integration and miniaturization of the power conversion device are facilitated.

According to a third aspect, this application provides an electric vehicle. The electric vehicle includes a powertrain and wheels. The powertrain includes a motor and the power conversion device provided in the second aspect. The motor is configured to drive the wheels to rotate. The power conversion device of the electric vehicle has higher integration and reliability, and occupies smaller space. This helps improve performance of the electric vehicle.

### BRIEF DESCRIPTION OF DRAWINGS

FIG. 1a is a diagram of a structure of an electric vehicle according to an embodiment of this application;
FIG. 1b is a diagram of a partial structure of an electric vehicle according to an embodiment of this application;
FIG. 2 is a diagram of a structure of a power module according to an embodiment of this application;
FIG. 3 is a diagram of a structure of a power chip of a power module according to an embodiment of this application;
FIG. 4 is a diagram of a partial structure of a power module according to an embodiment of this application;
FIG. 5a is a diagram of a structure of a power chip of a power module according to an embodiment of this application;
FIG. 5b is a diagram of a partial structure of a power module according to an embodiment of this application;
FIG. 6a is a diagram of a partial structure of a power module according to an embodiment of this application;
FIG. 6b is a diagram of a partial structure of a power module according to an embodiment of this application;
FIG. 7a is a diagram of a partial structure of a power module according to an embodiment of this application;
FIG. 7b is a diagram of a partial structure of a power module according to an embodiment of this application;
FIG. 8 is a diagram of a structure of a power module according to an embodiment of this application;
FIG. 9 is a diagram of a structure of a power module according to an embodiment of this application;
FIG. 10a is a diagram of a structure of a diode in a power module according to an embodiment of this application;
FIG. 10b is a diagram of a partial structure of a power module according to an embodiment of this application;
FIG. 11 is a diagram of a partial structure of a power module according to an embodiment of this application; and
FIG. 12 is a diagram of a structure of a power module according to an embodiment of this application.

### Reference numerals:

1000: powertrain; 2000: vehicle body; 3000: wheels; 4000: power battery;
100: motor control unit; 200: motor;
10: power module;
11: bottom plate; 111: insulation bottom plate; 112: first metal layer; 1121: first metal sublayer; 1122: second metal sublayer; 11221: alternating current output end; 1123: third metal sublayer; 113: second metal layer; 114: signal pad; 115: routing layer; 115a: first routing layer; 115b: second routing layer; 12: top plate; 121: insulation top plate; 122: third metal layer; 123: fourth metal layer; 2: power chip; 2a: first chip; 2b: second chip; 21: first electrode; 22: second electrode; 23: signal electrode; 231: gate signal electrode; 232: power signal electrode; 3: connection block; 4: connection terminal; 5: package body; 6: diode; 61: cathode; 62: anode;
Q: active region; V1: first group of chips; V2: second group of chips; W1: first group of diodes; and W2: second group of diodes.

### DESCRIPTION OF EMBODIMENTS

Use of a motor control unit, an industrial frequency converter, or the like of an electric vehicle imposes higher requirements on output power and integration of a power module. A conventional power module uses a single-sided heat dissipation structure. Heat generated by a power chip during operation is transferred to a bottom plate and a heat sink through a single-side insulation substrate. As a result, thermal resistance is large, an operating temperature is high, and an output capability of the module is restricted. In a power module with a double-sided heat dissipation design, a heat dissipation path is added on the top of the power chip, so that heat flux can be improved. The power module with double-sided heat dissipation usually integrates a large-sized transistor electronic component to improve a power processing capability. In a reliability assessment process like a power cycle, due to uneven temperature distribution of the electronic component and a ceramic substrate, local stress concentration may occur, which may cause cracking of the electronic component and the ceramic, and lead to a failure in the module's withstand voltage and insulation.

In view of this, embodiments of this application provide a power module, a power conversion device, and an electric vehicle. The power module can optimize a structure layout of the power module, to help improve heat dissipation and reliability of the power module.

To make objectives, technical solutions, and advantages of this application clearer, the following further describes this application in detail with reference to accompanying drawings.

Terms used in the following embodiments are merely intended to describe specific embodiments, but are not intended to limit this application. Terms "one", "a", "the", "the foregoing", "this", and "the one" of singular forms used in this specification and the appended claims of this application are also intended to include expressions such as "one or more", unless otherwise specified in the context clearly.

Reference to "an embodiment", "some embodiments", or the like described in this specification indicates that one or more embodiments of this application include a specific feature, structure, or characteristic described with reference to embodiments. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. Terms "include", "contain", "have", and their variants all mean "include but are not limited to", unless otherwise specifically emphasized in another manner.

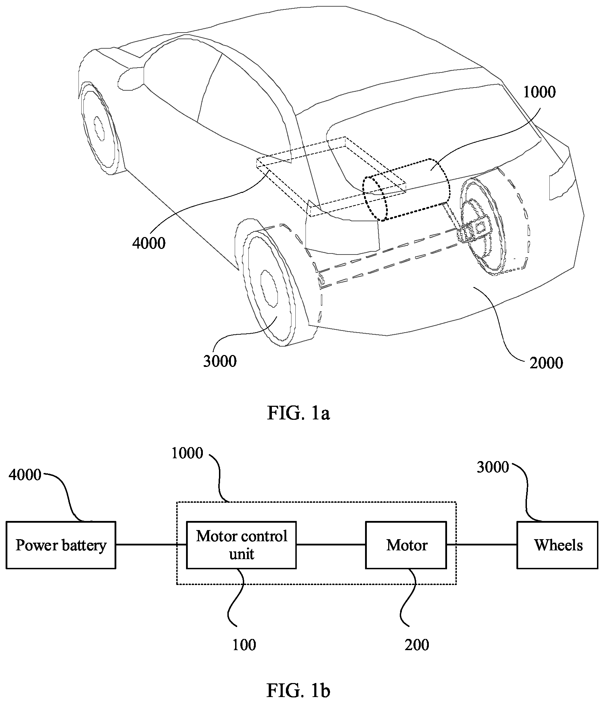

FIG. 1a shows an example of a structure of an electric vehicle according to an embodiment of this application. In this embodiment of this application, the electric vehicle is a wheeled device driven or towed by a power apparatus. In an implementation, the electric vehicle includes a special operation vehicle, for example, a passenger vehicle, a commercial vehicle, an engineering rescue vehicle, a sprinkler, a suction sewage truck, a cement mixer, a crane, or a medical vehicle. For example, the electric vehicle includes a pure electric vehicle (pure electric vehicle/battery electric vehicle, PEV/BEV), a hybrid electric vehicle (hybrid electric vehicle, HEV), a range extended electric vehicle (range extended electric vehicle, REEV), a plug-in hybrid electric vehicle (plug-in hybrid electric vehicle, PHEV), and the like.

As shown in FIG. 1a, the electric vehicle includes a power battery 4000, wheels 3000, a vehicle body 2000, and a powertrain 1000. The powertrain 1000, the power battery 4000, and the wheels 3000 are assembled on the vehicle body 2000.

As shown in FIG. 1b, the powertrain 1000 includes a motor control unit 100 and a motor 200. The motor control unit 100 is configured to receive a direct current of the power battery 4000, and is configured to output an alternating current to the motor 200. The motor 200 is configured to receive the alternating current output by the motor control unit 100, and is configured to drive the wheels 3000 of the electric vehicle. In an embodiment, the powertrain 1000 integrates the motor 200 and the motor control unit 100 into one housing, so that integration of the powertrain 1000 can be increased, and volume and costs can be reduced. This helps implement a lightweight design of the powertrain 1000 and improve power density.

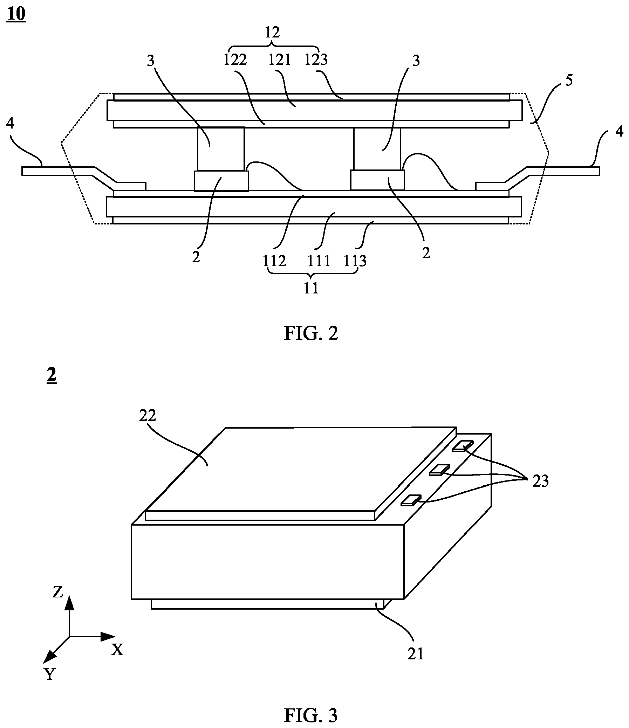

An embodiment of this application provides a power conversion device. The power conversion device may specifically include one or more power modules 10 shown in FIG. 2. Each power module 10 is a combination of power electronic components that can implement a power conversion function. Each power module 10 forms a power conversion circuit, and may convert a direct current into an alternating current or convert an alternating current into a direct current as required. When the power conversion device includes two or more power modules 10, the two or more power modules 10 may be integrated in a parallel manner. For example, a plurality of power modules 10 are disposed on a same circuit board or a same heat sink.

The power conversion device implements electric energy conversion via one or more power modules 10, and may be specifically used in the motor control unit 100 in FIG. 1b. In an example, each power module 10 included in the power conversion device may convert a direct current output by the power battery 4000 into an alternating current, and output the alternating current to the motor 200. The power module 10 may also be referred to as a power semiconductor module.

As shown in FIG. 2, the power module 10 provided in embodiments of this application includes a bottom plate 11 and a plurality of power chips 2. The plurality of power chips 2 are disposed on the bottom plate 11, and the plurality of power chips 2 can be electrically connected to form a functional circuit. Heat generated by each power chip 2 during operation may be transferred downward to the bottom plate 11 for heat dissipation.

For example, the power module 10 is a double-sided heat dissipation module. The power module 10 further includes a top plate 12 and a plurality of connection blocks 3. The bottom plate 11 and the top plate 12 are disposed opposite to each other and spaced from each other in a thickness direction. The top plate 12 is disposed on a side that is of the plurality of power chips 2 and that faces away from the bottom plate 11, and a surface that is of each power chip 2 and that faces away from the bottom plate 11 is connected, via one or more connection blocks 3, to a surface that is of the top plate 12 and that faces the bottom plate 11. Heat generated by each power chip 2 may also be transferred upward to the top plate 12 through the connection block 3 for heat dissipation. The power module 10 shown in FIG. 2 dissipates heat through both the upper surface and the lower surface of the module, so that heat can be dispersed, a heat diffusion area can be increased, and thermal resistance can be reduced, and heat conduction to an external heat sink or an environment can be accelerated. Better temperature uniformity can also reduce a risk of thermal stress damage to the module. The power module 10 having the double-sided heat dissipation structure can bear a larger current load, thereby improving power density and reliability.

In an embodiment, the bottom plate 11 is a direct bonded copper (direct bonded copper) board. A double-sided copper clad laminate (double-sided copper clad laminate, DCL) is used as an example. The bottom plate 11 includes an insulation bottom plate 111 and two metal layers respectively disposed on surfaces of two sides of the insulation bottom plate 111. For example, a metal layer disposed on a surface that is of the insulation bottom plate 111 and that faces the top plate 12 is a first metal layer 112, and a metal layer disposed on a surface that is of the insulation bottom plate 111 and that faces away from the top plate 12 is a second metal layer 113. The insulation bottom plate 111 may be an insulation material like ceramic or glass, and the first metal layer 112 and the second metal layer 113 are specifically copper layers. The first metal layer 112 and the second metal layer 113 may alternatively be aluminum layers or other conductive metal layers. The plurality of power chips 2 are disposed on the first metal layer 112, and heat generated by the plurality of power chips 2 may be transferred downward to the second metal layer 113 of the bottom plate 11 for heat dissipation.

Similarly, the top plate 12 includes an insulation top plate 121 and metal layers respectively disposed on surfaces of two sides of the insulation top plate 121. For example, a metal layer disposed on a surface that is of the insulation top plate 121 and that faces the bottom plate 11 is a third metal layer 122, and a metal layer disposed on a surface that is of the insulation top plate 121 and that faces away from the bottom plate 11 is a fourth metal layer 123. The insulation top plate 121 may be an insulation material like ceramic or glass, and the third metal layer 122 and the fourth metal layer 123 are specifically copper layers, aluminum layers, or other conductive metal layers. The third metal layer 122 is connected to the plurality of power chips 2 via the plurality of connection blocks 3, and heat generated by the plurality of power chips 2 may be transferred upward to the fourth metal layer 123 on a side that is of the top plate 12 and that faces away from the bottom plate 11 for heat dissipation.

Still refer to FIG. 2. Power chips 2 may be electrically connected through the first metal layer 112 and the third metal layer 122 to form a functional circuit. The power module 10 further includes a plurality of connection terminals 4, and each connection terminal 4 is connected to the first metal layer 112. One or more of the plurality of connection terminals 4 are used for current input of the functional circuit, and other one or more of the plurality of connection terminals 4 are used for current output of the functional circuit.

In some embodiments, the power module 10 further includes a package body. The package body 5 packages the bottom plate 11, the top plate 12, the plurality of power chips 2, the connection blocks 3, and a part of each connection terminal 4. An end that is of each connection terminal 4 and that faces away from the bottom plate 11 extends out of the package body 5, to facilitate connection to another electrical component.

FIG. 3 shows an example of a structure of the power chip 2. As shown in FIG. 3, the power chip 2 includes a first electrode 21, a second electrode 22, and a plurality of signal electrodes 23. In a thickness direction of the power chip 2, the first electrode 21 and the second electrode 22 are respectively disposed on two surfaces of the power chip 2, and the first electrode 21 and the second electrode 22 are disposed opposite to each other in the thickness direction of the power chip 2. The plurality of signal electrodes 23 are disposed on a surface that is of the power chip 2 and on which the second electrode 22 is disposed. It may be considered that the plurality of signal electrodes 23 and the second electrode 22 are distributed on a same surface of the power chip 2. When the power chip 2 is disposed on the first metal layer 112 of the bottom plate 11, the first electrode 21 of the power chip 2 is fastened to the first metal layer 112 through solder welding or silver sintering.

The power chip 2 is a semiconductor device having a gate. In some embodiments, the power chip 2 may be any one of an insulated gate bipolar transistor (insulated gate bipolar transistor, IGBT), a metal-oxide-semiconductor field-effect transistor (metal-oxide-semiconductor field-effect transistor, MOSFET), and a junction field-effect transistor (junction field-effect transistor, JFET). The insulated gate bipolar transistor features high voltage resistance and low conduction voltage drop, and may be widely applied to high-power electric energy conversion scenarios such as frequency conversion driving of a drive motor and grid-connected photovoltaic. Due to features such as a high-frequency switch and low drive power consumption, the metal-oxide-semiconductor field-effect transistor may be widely applied to scenarios such as power management, signal amplification, and a digital circuit.

When the power chip 2 is the insulated gate bipolar transistor, the first electrode 21 is a collector, and the second electrode 22 is an emitter. When the power chip 2 is the metal-oxide-semiconductor field-effect transistor, the first electrode 21 is a drain, and the second electrode 22 is a source.

For ease of illustration, a three-dimensional coordinate system is established by using the structure of the power chip 2 as a reference. The thickness direction of the power chip 2 is a third direction Z, two directions perpendicular to the third direction Z are respectively a first direction X and a second direction Y, and the first direction X and the second direction Y are perpendicular to each other. The structure of the power chip 2 shown in FIG. 3 is used as an example. The first direction X may be one of a length direction or a width direction of the power chip 2, and the second direction Y may be the other of the length direction or the width direction of the power chip 2.

In an embodiment, the first electrode 21 and the second electrode 22 are respectively disposed on two surfaces of the power chip 2 in the third direction Z, and the first electrode 21 and the second electrode 22 face away from each other in the third direction Z. The plurality of signal electrodes 23 are disposed on the surface that is of the power chip 2 and that faces away from the first electrode 21 in the third direction Z, and each signal electrode 23 and the second electrode 22 are spaced from each other to implement insulation.

As shown in FIG. 3, the plurality of signal electrodes 23 are used as a combination, and the second electrode 22 and the combination of the plurality of signal electrodes 23 are spaced from each other in the first direction X. In the power module 10, the second electrode 22 is configured to abut against the connection block 3, and the plurality of signal electrodes 23 are regularly arranged. This helps reduce a risk of a short circuit between the signal electrode 23 and the connection block 3.

As shown in FIG. 3, each signal electrode 23 is used as an independent individual, and the plurality of signal electrodes 23 are spaced from each other in the second direction Y, so that the signal electrodes 23 are connected through routing as required.

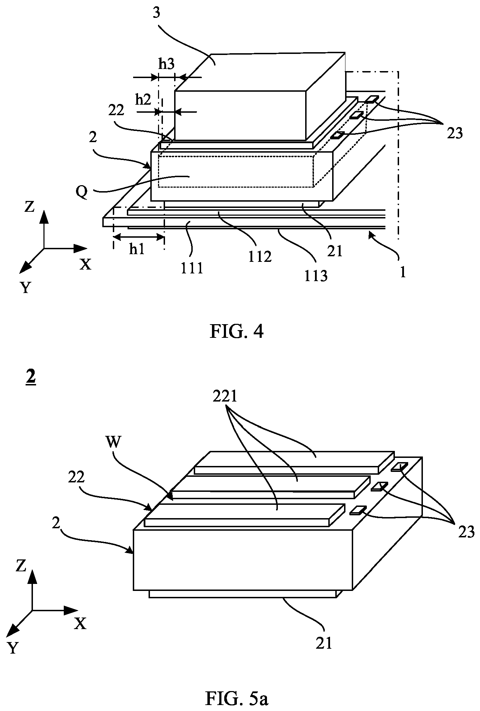

FIG. 4 shows an example of a partial structure of the power chip 2, the bottom plate 11, and the connection block 3 in the power module 10 according to an embodiment of this application. As shown in FIG. 4, a thickness direction of the power module 10 is the thickness direction of the power chip 2, and is specifically an arrangement direction of the first electrode 21 and the second electrode 22 of the power chip 2, that is, the third direction Z. The surface that is of the power chip 2 and on which the first electrode 21 is located faces the first metal layer 112 of the bottom plate 11, and the power chip 2 may be electrically connected to the first metal layer 112 via the first electrode 21. The surface that is of the power chip 2 and on which the second electrode 22 is located faces away from the first metal layer 112 of the bottom plate 11, and the power chip 2 may be electrically connected to the connection block 3 via the second electrode 22.

In an embodiment, in the third direction Z, an orthographic projection of the power chip 2 on the insulation bottom plate 111 is within a range of the insulation bottom plate 111. Mechanical stress is generated at a joint between an edge of the first metal layer 112 and the insulation bottom plate 111. The power chip 2 is disposed on the first metal layer 112, and mechanical stress is also generated at a joint between an edge of the power chip 2 and the first metal layer 112. Repeated switching of the power chip 2 affects a mechanical stress change of the insulation bottom plate 111 through the first metal layer 112. A coefficient of thermal expansion of the insulation bottom plate 111 is different from coefficients of thermal expansion of the first metal layer 112 and the power chip 2, and therefore a temperature change caused by repeated switching of the power chip 2 further causes thermal stress to be generated inside the insulation bottom plate 111. Heat generated by the power chip 2 during operation may be transferred to the insulation bottom plate 111 through the first metal layer 112. This further aggravates stress concentration of the insulation bottom plate 111, and causes a phenomenon of unbalanced temperature and stress distribution on the insulation bottom plate 111. The insulation bottom plate 111 is usually made of a ceramic material and has high brittleness. Unbalanced temperature and stress distribution of the insulation bottom plate 111 may cause a risk of warping, a crack, or even a fracture. If the insulation bottom plate 111 is warped, cracked, or even broken, reliability of the power module 10 is affected, and a risk of a module failure occurs. A crack or even a fracture of the insulation bottom plate 111 affects insulation effect of the insulation bottom plate 111. If the insulation bottom plate 111 fails to be insulated, a short circuit may be caused between the first metal layer 112 and the second metal layer 113, and a leakage risk may occur.

In view of this, as shown in FIG. 4, distribution of the power chip 2 relative to the bottom plate 11 is designed for the power module 10 provided in embodiments of this application, to balance temperature and stress distribution of the insulation bottom plate 111 of the bottom plate 11.

In an embodiment, in any direction perpendicular to the third direction Z, a spacing h1 between the power chip 2 and an edge of the insulation bottom plate 111 is greater than or equal to 3 mm, so that there is a sufficient spacing between the power chip 2 and the edge of the insulation bottom plate 111, to prevent the power chip 2 from causing a large mechanical stress change of the insulation bottom plate 111. The spacing between the power chip 2 and the edge of the insulation bottom plate 111 is a spacing between the edge of the insulation bottom plate 111 and a joint between the power chip 2 and the insulation bottom plate 111.

There is a sufficient spacing between the power chip 2 and the edge of the insulation bottom plate 111. When a heat change in a switching process of the power chip 2 is transferred to the insulation bottom plate 111, the insulation bottom plate 111 has a sufficiently large region for heat to be evenly distributed, to improve temperature distribution balance of the insulation bottom plate 111, and reduce a risk of excessive stress concentration. Improving temperature and stress distribution balance of the insulation bottom plate 111 can reduce a risk of warping, a crack, or a fracture of the insulation bottom plate 111, and improve insulation and stability of the module, so that the power module 10 has good performance in reliability assessment.

In an embodiment, still referring to FIG. 4, in the third direction Z, an orthographic projection of the connection block 3 on the second electrode 22 of the power chip 2 falls within a range of the second electrode 22.

Mechanical stress is generated when an edge of the connection block 3 is connected to the second electrode 22, and heat generated by the power chip 2 also causes thermal stress to be generated inside the power chip 2. Repeated switching of the power chip 2 affects a stress change of the second electrode 22. A part of heat generated by the power chip 2 during operation needs to be transferred to the top plate 12 through the second electrode 22 for heat dissipation. A contact area between the second electrode 22 and the connection block 3 and a contact position affect heat dissipation of the power chip 2. If stress and temperature distribution inside the power chip 2 are unbalanced, the power chip 2 may have a risk of a crack or a fracture, affecting function implementation of the module.

In view of this, as shown in FIG. 4, distribution of the power chip 2 and the connection block 3 is designed for the power module 10 provided in embodiments of this application, to balance temperature and stress distribution of the power chip 2.

In an embodiment, in any direction perpendicular to the third direction Z, a spacing h2 between the connection block 3 and an edge of the second electrode 22 is 0.2 mm to 0.5 mm, so that the connection block 3 can be in contact with the second electrode 22 of the power chip 2 in a large range, thereby ensuring high efficiency of the heat transfer channel. The spacing between the connection block 3 and the edge of the second electrode 22 is a spacing between the edge of the second electrode 22 and a joint between the connection block 3 and the insulation bottom plate 111. The spacing h2 is reserved between the connection block 3 and the edge of the second electrode 22, so that it can be ensured that force transferred by the connection block 3 to the power chip 2 does not increase stress generated inside the power chip 2. Improving temperature and stress distribution balance of the power chip 2 can reduce a risk of a crack or a fracture of the power chip 2, and improve stability of the module, so that the power module 10 has good performance in reliability assessment.

Still refer to FIG. 4. A conductive region that is in the power chip 2 and that is configured to perform a switch function is an active region Q of the power chip 2. When the power chip 2 operates, the active region Q generates a large amount of heat. In an embodiment, in the third direction Z, an orthographic projection of the connection block 3 on the second electrode 22 of the power chip 2 falls within a range of the active region Q. The active region Q with large heat of the power chip 2 corresponds to the connection block 3 in the third direction Z, and the heat of the active region Q can be transferred to the connection block 3 at a short heat conduction distance. In any direction perpendicular to the third direction Z, a spacing h3 between an edge of the active region Q and the edge of the connection block 3 is less than or equal to 0.5 mm, and an area in which the connection block 3 is in contact with the second electrode 22 of the power chip 2 adapts to the range of the active region Q, to enhance heat conduction effect, and further balance the temperature distribution and the stress distribution in the power chip 2.

It should be understood that, as shown in FIG. 4, for all of the spacing h1 between the power chip 2 and the edge of the insulation bottom plate 111, the spacing h2 between the connection block 3 and the edge of the power chip 2, and the spacing h3 between the edge of the active region Q and the edge of the connection block 3, one direction perpendicular to the third direction Z is used as an example. A spacing between the power chip 2 and the edge of the insulation bottom plate 111 in another direction perpendicular to the third direction Z also meets a condition of the spacing h1, and a spacing between the connection block 3 and the edge of the power chip 2 in another direction perpendicular to the third direction Z also meets a condition of the spacing h2, and a spacing between the edge of the active region Q and the edge of the connection block 3 in another direction perpendicular to the third direction Z also meets a condition of the spacing h3.

FIG. 5a shows a power chip 2 of another structure. A difference from the power chip 2 shown in FIG. 3 lies in that the second electrode 22 in FIG. 5a includes a plurality of sub-electrodes 221, and any two sub-electrodes 221 are isolated from each other. In a structure example, the plurality of sub-electrodes 221 are regularly distributed.

In an embodiment, in the second direction Y, the plurality of sub-electrodes 221 are spaced from each other, and there is a gap between any two sub-electrodes 221. The plurality of sub-electrodes 221 form the second electrode 22 of the power chip 2, so that electromagnetic interference can be reduced, and current distribution inside the power chip 2 can be more even. This helps balance temperature and stress distribution of the power chip 2. Based on the structure of the second electrode 22, the plurality of sub-electrodes 221 and the gap between any two sub-electrodes 221 are considered as a region W occupied by the second electrode 22, and the region W occupied by the second electrode 22 is shown by using a shadow.

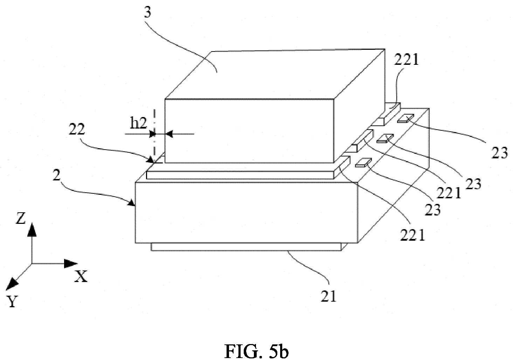

FIG. 5b shows a cooperation manner between the power chip 2 shown in FIG. 5a and the connection block 3. As shown in FIG. 5b, the plurality of sub-electrodes 221 of the power chip 2 are connected to one connection block 3, and the connection block 3 is in contact with a surface that is of each sub-electrode 221 and that faces away from the first electrode 21. For two adjacent sub-electrodes 221, the connection block 3 is equivalent to being bridged between the two sub-electrodes 221. Therefore, in an embodiment, in the third direction Z, an orthographic projection of the connection block 3 in the region W occupied by the second electrode 22 of the power chip 2 is within a range of the region W occupied by the second electrode 22. In any direction perpendicular to the third direction Z, the spacing h2 between the connection block 3 and an edge of the region W occupied by the second electrode 22 is 0.2 mm to 0.5 mm, so that the connection block 3 can be in contact with the second electrode 22 in a large range, thereby ensuring high efficiency of the heat transfer channel.

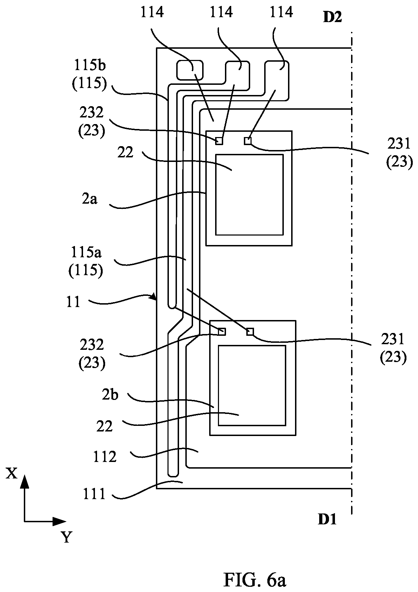

FIG. 6a is a top view of a partial structure of the power module 10 according to an embodiment of this application. As shown in FIG. 6a, the power module 10 shows a partial structure of the bottom plate 11. The first metal layer 112 is disposed on a surface of the insulation bottom plate 111, and the plurality of power chips 2 are disposed on the first metal layer 112. A first electrode 21 of each power chip 2 faces the first metal layer 112 and is connected to the first metal layer 112, and the first electrode 21 is shielded (not shown). A second electrode 22 of each power chip 2 is located on a surface that is of the power chip 2 and that faces away from the first metal layer 112, and the plurality of signal electrodes 23 of each power chip 2 are also located on a surface that is of the power chip 2 and that faces away from the first metal layer 112. A structure of one power chip 2 is used as an example. In the first direction X, the plurality of signal electrodes 23 as a whole and the second electrode 22 are spaced from each other.

As shown in FIG. 6a, the bottom plate 11 further includes a plurality of signal pads 114, and the signal pads 114 are configured to connect to signal terminals of the power module 10. The plurality of signal pads 114 are disposed on a surface that is of the first metal layer 112 and that faces away from the insulation bottom plate 111. The power module 10 may implement a control signal connection to an external control circuit via the signal pad 114.

In an embodiment, in the first direction X, the plurality of signal pads 114 are disposed on one side of the first metal layer 112. The plurality of signal pads 114 are used as a combination of signal pads, the plurality of power chips 2 are used as a combination of power chips, and the combination of the signal pads and the combination of the power chips are spaced from each other in the first direction X. To facilitate a connection between the power chip 2 and the signal pad 114 and reduce a routing distance, a signal electrode 23 of each power chip 2 faces a side on which the plurality of signal pads 114 are located. A structure of the entire power module 10 is used as a reference. A plurality of signal electrodes 23 of each power chip 2 are arranged between the plurality of signal pads 114 and the second electrode 22 in the first direction X. A connection routing distance between the signal electrode 23 of the power chip 2 and the signal pad 114 is reduced, so that a spatial layout of the power module 10 can be optimized. This helps reduce volume of the power module 10 and implement device miniaturization.

As shown in FIG. 6a, distribution of the plurality of power chips 2 on the first metal layer 112 is staggered in the first direction X, a distance between one power chip 2 and the plurality of signal pads 114 in the first direction X is different from a distance between another power chip 2 and the plurality of signal pads 114 in the first direction X. To facilitate connection between different power chips 2 and the signal pad 114, the bottom plate 11 further includes a plurality of routing layers 115. A first end of each routing layer 115 is connected to one signal pad 114, and a second end extends to be arranged between the first metal layer 112 and the edge of the insulation bottom plate 111 in the second direction Y.

In the first direction X, the second end of each routing layer 115 extends to a side away from the signal pad 114. For ease of understanding, a side that is of the insulation bottom plate 111 and on which the plurality of signal pads 114 are disposed is considered as a first end side D1, a side that is of the insulation bottom plate 111 and that is away from the plurality of signal pads 114 is set as a second end side D2, and the first end side D1 and the second end side D2 are opposite to each other in the first direction X. In the first direction X, a spacing between each routing layer 115 and the second end side D2 is less than a spacing between any signal pad 114 and the second end side D2. For the plurality of power chips 2, signal electrodes 23 of one or more power chips 2 that are close to the signal pad 114 may be directly connected to the signal pad 114, and signal electrodes 23 of one or more power chips 2 that are far away from the signal pad 114 may be connected to the nearby routing layer 115 and further implement a circuit connection to the signal pad 114 through the routing layer 115.

In an embodiment, the routing layer 115 is used for routing of a signal circuit of the power chip 2, and requires small layout space. In the second direction Y, widths of the plurality of routing layers 115 included in the power module 10 are less than a width of the first metal layer 112. Each routing layer 115 is arranged between the first metal layer 112 and the edge of the insulation bottom plate 111, and the routing layer 115 does not affect a structure layout of the first metal layer 112 and the related power chip 2.

In an embodiment, it should be understood that each power chip 2 includes a plurality of signal electrodes 23, and different types of signal electrodes 23 need to be connected to different types of signal pads 114. For example, the plurality of signal electrodes 23 of each power chip 2 include at least one power signal electrode 232 and at least one gate signal electrode 231, the at least one gate signal electrode of each power chip 2 is connected to one signal pad 114 or one routing layer 115, and the at least one power signal electrode of each power chip 2 is connected to one signal pad 114 or one routing layer 115.

In the power module 10, any power chip 2 may be electrically connected to a nearby control signal of a signal pad 114, so that a spatial layout of the power module 10 can be optimized. Each routing layer 115 is at least partially arranged between the first metal layer 112 and the edge of the insulation bottom plate 111 in the second direction Y, so that force balance of the insulation bottom plate 111 can be improved, and a risk of fracture or warping of the insulation bottom plate can be reduced, thereby improving structural reliability of the module.

Still refer to FIG. 6a. For example, the plurality of power chips 2 include a first chip 2a and a second chip 2b. The first chip 2a and the second chip 2b are spaced from each other in the first direction X, the first chip 2a is arranged between and spaced from the plurality of signal pads 114 and the second chip 2b in the first direction X, and a distance between the first chip 2a and the plurality of signal pads 114 is less than a distance between the second chip 2b and the plurality of signal pads 114. The first chip 2a is close to the plurality of signal pads 114, and may be directly connected to the plurality of signal pads 114 via conductors such as bonding wires.

The first chip 2a is arranged between and spaced from the second chip 2b and the plurality of signal pads 114. A power signal electrode 232 of the first chip 2a is connected to one signal pad 114, a gate signal electrode 231 of the first chip 2a is connected to another signal pad 114, a power signal electrode 232 of the second chip 2b is connected to one routing layer 115, and a gate signal electrode 231 of the second chip 2b is connected to another routing layer 115. The second chip 2b is connected to a signal circuit of the signal pad 114 through the two routing layers 115, to avoid a case in which a direct routing connection between the second chip 2b and the plurality of signal pads 114 needs to cross the first chip 2a, thereby reducing a short-circuit risk. A circuit connection between the second chip 2b and the two routing layers 115 is also more reliable, which facilitates a proper space layout of the module.

For the first chip 2a and the second chip 2b shown in FIG. 6a, at least two routing layers 115 are disposed, one routing layer 115 is configured to connect the gate signal electrode 231 of the second chip 2b to one signal pad 114, and the other routing layer 115 is configured to connect the power signal electrode 232 of the second chip 2b to another signal pad 114. In an embodiment, the first chip 2a and the second chip 2b are connected in parallel, the one signal pad 114 connected to the power signal electrode 232 of the first chip 2a is connected to the one routing layer 115 connected to the power signal electrode 232 of the second chip 2b, and the another signal pad 114 connected to the gate signal electrode 231 of the first chip 2a is connected to the another routing layer 115 connected to the gate signal electrode 231 of the second chip 2b. The power signal electrodes 232 of the first chip 2a and the second chip 2b share one signal pad 114, and the gate signal electrodes 231 of the first chip 2a and the second chip 2b share another signal pad 114.

In the module structure shown in FIG. 6a, a plurality of signal electrodes 23 included in the second device 2b are spaced from each other in the second direction Y, and at least parts of the two routing layers 115 are spaced from each other in the second direction Y. In an embodiment, an arrangement manner of the gate signal electrode 231 and the power signal electrode 232 of the second device 2b is the same as an arrangement manner of the routing layer 115 connected to the gate signal electrode 231 and the routing layer 115 connected to the power signal electrode 232, to avoid mutual interference between wires.

As shown in FIG. 6a, the plurality of routing layers 115 include a first routing layer 115a and a second routing layer 115b. In the second direction Y, a part of the first routing layer 115a and a part of the second routing layer 115b are adjacently arranged between the first chip 2a and the edge of the insulation bottom plate 111, and the part of the first routing layer 115a and the part of the second routing layer 115b occupy space between the first chip 2a and the edge of the insulation bottom plate 111, and do not affect circuit routing and layout of the first chip 2a. The part of the first routing layer 115a and the part of the second routing layer 115b are arranged in the second direction Y, to prevent the first routing layer 115a and the second routing layer 115b from extending in the first direction X.

In an embodiment, the part of the first routing layer 115a is arranged between the first chip 2a and the part of the second routing layer 115b. The power signal electrode 232 of the second chip 2b is arranged between the first routing layer 115a and the gate signal electrode 231 of the second chip 2b in the second direction Y, the power signal electrode 232 of the second chip 2b is connected to the second routing layer 115b, and the gate signal electrode 231 of the second chip 2b is connected to the first routing layer 115a. A connection between the power signal electrode 232 of the second chip 2b and the second routing layer 115b can avoid a connection between the gate signal electrode 231 of the second chip 2b and the first routing layer 115a, to further optimize a structure layout of the module.

In a structure example, in the first direction X, a connection position between the gate signal electrode 231 of the second chip 2b and the first routing layer 115a and a connection position between the power signal electrode 232 of the second chip 2b and the second routing layer 115b are both located between the first chip 2a and the second chip 2b. In this way, the second chip implements a signal circuit connection through the routing layer 115. A routing direction of a connection between the gate signal electrode 231 of the second chip 2b and the first routing layer 115a is arranged at an included angle relative to the first direction X, and a routing direction of a connection between the power signal electrode 232 of the second chip 2b and the second routing layer 115b is arranged at an included angle relative to the first direction X. This helps avoid mutual interference between two wires.

The connection position between the gate signal electrode 231 of the second chip 2b and the first routing layer 115a and the connection position between the power signal electrode 232 of the second chip 2b and the second routing layer 115b may be staggered in the first direction X, to implement avoidance and optimize a module layout. Specifically, in the first direction X, the connection position between the power signal electrode 232 of the second chip 2b and the second routing layer 115b is located on a side that is of the connection position between the gate signal electrode 231 of the second chip 2b and the first routing layer 115a and that is away from the plurality of signal pads 114. This can prevent a connection line between the gate signal electrode of the second chip 2b and the first routing layer 115a from crossing a connection line between the power signal electrode of the second chip 2b and the second routing layer 115b, thereby reducing a short-circuit risk. It may also be considered that, in the first direction X, the connection position between the gate signal electrode of the second chip 2b and the first routing layer 115a is closer to the side of the plurality of signal pads 114 than the connection position between the power signal electrode 232 of the second chip 2b and the second routing layer 115b, and the connection position between the power signal electrode 232 of the second chip 2b and the second routing layer 115b is closer to the first end side D1 than the connection position between the gate signal electrode of the second chip 2b and the first routing layer 115a.

In an embodiment, in the first direction X, a length of the first routing layer 115a is greater than a length of the second routing layer 115b. The first routing layer 115a and the second routing layer 115b have different length layouts, the position at which the first routing layer 115a is connected to the gate signal electrode 231 of the second chip 2b and the position at which the second routing layer 115b is connected to the power signal electrode 232 of the second chip 2b may be arranged in a staggered manner in the first direction X. This helps optimize a circuit routing layout and avoid a short circuit.

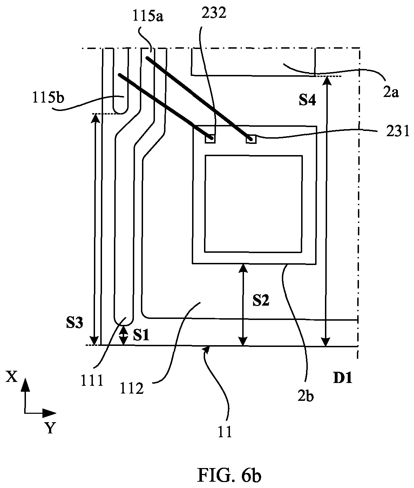

Specifically, a spacing between the first routing layer 115a and an end that is of the insulation bottom plate 111 and that is away from the plurality of signal pads 114 is less than a spacing between the second routing layer 115b and the end that is of the insulation bottom plate 111 and that is away from the plurality of signal pads 114. The end that is of the insulation bottom plate 111 and that is away from the plurality of signal pads 114 is the first end side D1. As shown in FIG. 6a and FIG. 6b, a spacing S1 between the first routing layer 115a and the end that is of the insulation bottom plate 111 and that is away from the plurality of signal pads 114 is less than a spacing S2 between the second chip 2b and the end that is of the insulation bottom plate 111 and that is away from the plurality of signal pads 114. The end that is of the insulation bottom plate 111 and that is away from the plurality of signal pads 114 is the first end side D1. In other words, the first routing layer 115a extends between the second chip 2b and the first end side D1 of the insulation bottom plate 111 in the first direction X, and a part of the first routing layer 115a is arranged between the second chip 2b and the edge of the insulation bottom plate 111 in the second direction Y, so that internal stress of the insulation bottom plate 111 can be further uniform, and structural reliability of the bottom plate 11 and the module can be improved.

Still refer to FIG. 6b. A spacing S3 between the second routing layer 115b and the end that is of the insulation bottom plate 111 and that is away from the plurality of signal pads 114 is less than a spacing S4 between the first chip 2a and the end that is of the insulation bottom plate 111 and that is away from the plurality of signal pads 114. The second routing layer 115b may meet a nearby circuit connection of the power signal electrode 232 of the second chip 2b.

It should be understood that the lengths of the first routing layer 115a and the second routing layer 115b in the first direction X may also be adjusted as required. For example, the length of the first routing layer 115a in the first direction X is less than or equal to the length of the second routing layer 115b in the first direction X, provided that the lengths of the first routing layer 115a and the second routing layer 115b further balance force applied to the bottom plate 11 on the basis that the lengths of the first routing layer 115a and the second routing layer 115b also meet the circuit connection.

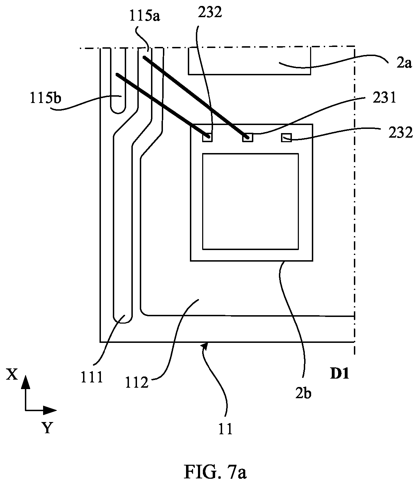

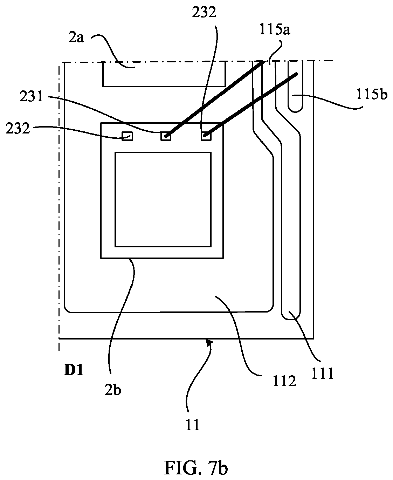

In an embodiment, as shown in FIG. 7a and FIG. 7b, each power chip 2 includes at least one gate signal electrode 231 and at least two power signal electrodes 232, and one gate signal electrode 231 is arranged between two power signal electrodes 232 in the second direction Y. When the power chip 2 is used as the second chip 2b, regardless of whether the two routing layers 115 are arranged on the left side or the right side of the second chip 2b in the second direction Y, at least one power signal electrode 232 of the second chip 2b is arranged between the two routing layers 115 and the gate signal electrode 231 in the second direction Y. The gate signal electrode 231 may be connected to one signal pad 114 through the first routing layer 115a, to implement connection of a gate control circuit, and one of the two power signal electrodes 232 that is closer to the two routing layers 115 in the second direction Y is configured to connect to one signal pad 114 through the second routing layer 115b, to implement connection of a power electrode control circuit.

Specifically, as shown in FIG. 7a and FIG. 7b, in the two power signal electrodes 232, in the second direction Y, one power signal electrode 232 is arranged between and spaced from the gate signal electrode 231 and the edge of the first metal layer 112, and the other power signal electrode 232 is arranged on a side that is of the gate signal electrode 231 and that is away from the edge of the first metal layer 112. The power signal electrode 232 arranged between and spaced from the gate signal electrode 231 and the edge of the first metal layer 112 is connected to the routing layer 115, so that a routing path can be reduced, connection reliability can be improved, and a module space layout can be optimized.

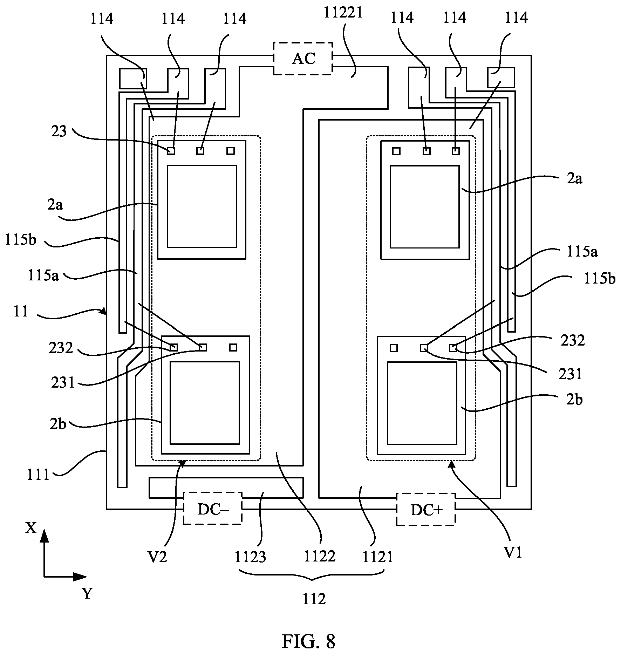

In an embodiment, FIG. 8 is a top view of a partial structure of the power module 10. The plurality of power chips 2 include two groups of chips, the two groups of chips are spaced from each other in the second direction, and the two groups of chips are respectively a first group of chips V1 and a second group of chips V2. Each group of chips includes a plurality of power chips 2 connected in parallel, and the plurality of power chips 2 are spaced from each other in the first direction X.

In a structure example, each group of chips includes a first chip 2a and a second chip 2b. Correspondingly, the plurality of routing layers 115 include two groups of routing layers, and each group of routing layers 115 includes a first routing layer 115a and a second routing layer 115b. The two groups of routing layers are respectively arranged on two sides of the first metal layer 112 in the second direction Y, a power signal electrode 232 of the second chip 2b in each group of chips is connected to a second routing layer 115b in an adjacent group of routing layers, and a gate signal electrode 231 of the second chip 2a in each group of chips is connected to a first routing layer 115a in an adjacent group of routing layers. The two groups of chips are respectively connected to the signal pad 114 through one group of routing layers, to improve force balance of the bottom plate 11 in the second direction, and further improve structural reliability of the module.

As shown in FIG. 8, the first metal layer 112 includes a first metal sublayer 1121, a second metal sublayer 1122, and a third metal sublayer 1123. The first metal sublayer 1121, the second metal sublayer 1122, and the third metal sublayer 1123 are isolated from each other. The first group of chips V1 is disposed on the first metal sublayer 1121, a first electrode 21 of each power chip 2 in the first group of chips V1 is connected to the first metal sublayer 1121, the second electrode 22 is configured to connect to the second metal sublayer 1122, and the first group of chips V1 are electrically connected to form an upper bridge arm of a bridge arm circuit. The second group of chips V2 is disposed on the second metal sublayer 1122, the second group of chips V2 includes a plurality of power chips 2, a first electrode 21 of each power chip 2 is connected to the second metal sublayer 1122, a second electrode 22 is configured to connect to the third metal sublayer 1123, and the second group of chips V2 are electrically connected to form a lower bridge arm of the bridge arm circuit. The first metal sublayer 1121 and the third metal sublayer 1123 are respectively used for direct current positive and negative electrode input of the bridge arm circuit, and the second metal sublayer 1122 is used for alternating current output of the bridge arm circuit. In a structure example, the first metal sublayer 1121 is used for direct current positive electrode input, and the third metal sublayer 1123 is used for direct current negative electrode input.

Still as shown in FIG. 8, the first group of chips V1 and the second group of chips V2 are symmetrically arranged in the second direction Y. This facilitates a more regular structure layout of the module, facilitates routing connection, further balances temperature and stress distribution of the insulation bottom plate 111 of the bottom plate 11, and improves reliability of the module.

In an embodiment, correspondingly, the plurality of signal pads 114 are divided into two groups, and each group of chips and one group of signal pads 114 are spaced from each other in the first direction X. Between one group of chips and one group of signal pads 114 that correspond to each other in the first direction X, a signal electrode of each power chip 2 in the group of chips may be directly connected to the group of signal pads 114 or connected to the group of signal pads 114 through the routing layer 115, to implement a control signal connection. This can facilitate respective signal routing of the upper bridge arm and the lower bridge arm, reduce routing paths, and improve reliability.

The second chip 2b in each group of chips may be connected to a corresponding group of signal pads 114 through a corresponding first routing layer 115a and a corresponding second routing layer 115b. Through such a structure layout, a structural arrangement of the power module 10 is further optimized, and temperature distribution and stress distribution of the power module 10 are balanced.

In an embodiment, the first metal layer 112 includes an input side and an output side, and the input side and the output side are opposite to each other in the first direction X. The input side and the first end side D1 of the bottom plate 11 are a same side, and the output side and the second end side D2 of the bottom plate 11 are a same side. In the second direction Y, a length of the input side is greater than a length of the output side, and each signal pad 114 and the output side of the first metal layer 112 are spaced from each other. Specifically, there are two input sides: an end that is of the first metal sublayer 1121 and that is used for current input, and an end that is of the third metal sublayer 1123 and that is used for current input. The output side is an end that is of the second metal sublayer 1122 and that is used for current output. For example, the second metal sublayer 1122 includes an alternating current output end 11221, and the alternating current output end 11221 and the plurality of signal pads 114 are spaced from each other in the second direction Y. Specifically, the alternating current output end 11221 is arranged between two parts of signal pads 114 in the second direction Y. The plurality of signal pads 114 and the alternating current output end 11221 are disposed on a same side of the insulation bottom plate 111 in the first direction X, so that space can be saved.

In some embodiments, the first metal sublayer 1121, the second metal sublayer 1122, the third metal sublayer 1123, the plurality of signal pads 114, and the plurality of routing layers 115 provided in embodiments of this application are all copper layers or other metal layers with good conductivity. During manufacturing of the power module 10, a metal layer may be formed on the insulation bottom plate 111 through a same-layer manufacturing process, and then the metal layer is cut into metal sublayers with different functions through etching, development, or the like.

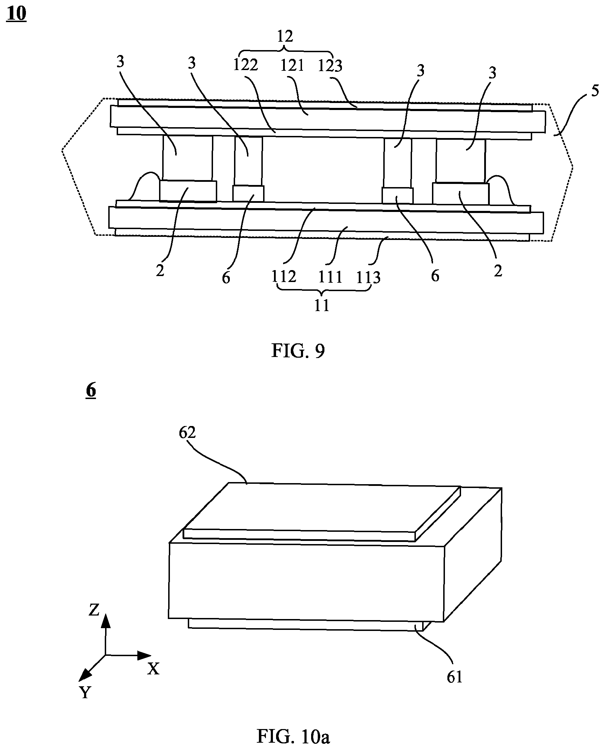

In an embodiment, FIG. 9 shows a power module 10. The power module 10 further includes a plurality of diodes 6, and each diode 6 is disposed on the surface that is of the first metal layer 112 and that faces away from the insulation bottom plate 111, that is, the plurality of power chips 2 and the plurality of diodes 6 are disposed on the first metal layer 112 in a same-layer distribution manner. In an embodiment, each power chip 2 is connected in parallel to one diode 6.

In an example, the power chip 2 is an insulated gate bipolar transistor, and the diode 6 connected in parallel to the power chip 2 is a fast recovery diode (fast recovery diode, FRD) or a silicon carbide-based Schottky barrier diode (Schottky barrier diode, SBD).

As shown in FIG. 9, a surface that is of each diode 6 and that faces the bottom plate 11 is connected to the first metal layer 112, and a surface that is of each diode 6 and that faces away from the bottom plate 11 is connected to the third metal layer 122 of the top plate 12 via one or more connection blocks 3, to implement parallel connection between the diode 6 and the corresponding power chip 2.

FIG. 10a shows an example of a structure of the diode 6. As shown in FIG. 10a, the diode 6 includes two electrodes: a cathode 61 and an anode 62. In the third direction Z, namely, in a thickness direction of the diode 6 or a thickness direction of the bottom plate 11, the cathode 61 and the anode 62 are respectively located on two surfaces of the diode 6, the diode 6 is connected to the first metal layer 112 of the bottom plate 11 through the cathode 61, and the anode 62 of the diode 6 is configured to connect to the connection block 3.

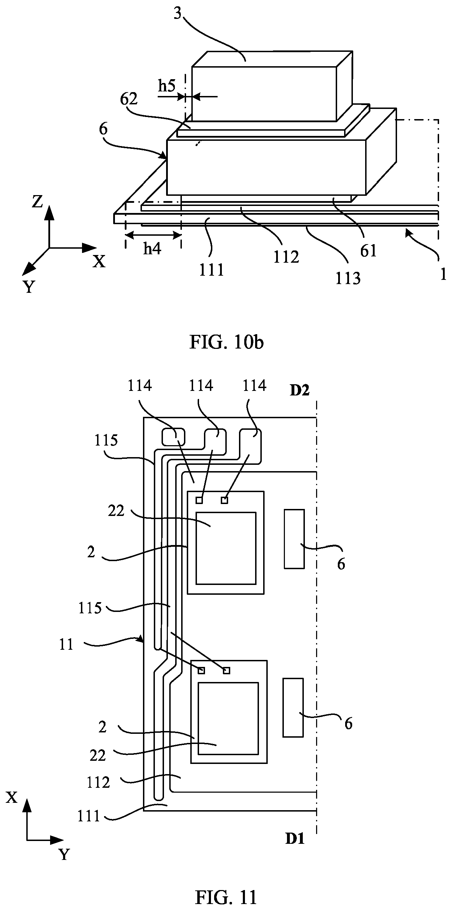

FIG. 10b shows an example of a partial structure of the diode 6, the bottom plate 11, and the connection block 3 in the power module 10 according to an embodiment of this application. The thickness direction of the power module 10 is also the thickness direction of the diode 6, and is specifically an arrangement direction of the cathode 61 and the anode 62 of the diode 6, that is, the third direction Z. The surface that is of the diode 6 and on which the cathode 61 is located faces the first metal layer 112 of the bottom plate 11, and the diode 6 may be electrically connected to the first metal layer 112 via the cathode 61. The surface that is of the diode 6 and on which the anode 62 is located faces away from the first metal layer 112 of the bottom plate 11, and the diode 6 may be electrically connected to the connection block 3 through the anode 62.

In an embodiment, in the third direction Z, an orthographic projection of the diode 6 on the insulation bottom plate 111 is within a range of the insulation bottom plate 111. Mechanical stress is generated at a joint between the edge of the first metal layer 112 and the insulation bottom plate 111. The diode 6 is disposed on the first metal layer 112, and mechanical stress is also generated at a joint between an edge of the diode 6 and the first metal layer 112. The coefficient of thermal expansion of the insulation bottom plate 111 is different from coefficients of thermal expansion of the first metal layer 112 and the diode 6, and a temperature change generated when the diode 6 operates may further cause thermal stress to be generated inside the insulation bottom plate 111. Heat generated by the diode 6 during operation may be transferred to the insulation bottom plate 111 through the first metal layer 112, which further aggravates stress concentration of the insulation bottom plate 111. As a result, temperature and stress distribution of the insulation bottom plate 111 are unbalanced, the insulation bottom plate 111 has a risk of warping, cracks, or even fracture, and reliability of the power module 10 is further affected. Certainly, a crack or even a fracture of the insulation bottom plate 111 affects insulation effect of the insulation bottom plate 111. If the insulation bottom plate 111 fails to be insulated, a short circuit may be caused between the first metal layer 112 and the second metal layer 113, and a leakage risk may occur.

In view of this, as shown in FIG. 10b, distribution of the diode 6 and the bottom plate 11 is designed for the power module 10 provided in embodiments of this application, to balance temperature and stress distribution of the insulation bottom plate 111. Specifically, in any direction perpendicular to the third direction Z, a spacing h4 between the diode 6 and the edge of the insulation bottom plate 111 is greater than or equal to 3 mm, so that there is a sufficient spacing between the diode 6 and the edge of the insulation bottom plate 111, to prevent the diode 6 from causing a large mechanical stress change of the insulation bottom plate 111. There is a sufficient spacing between the diode 6 and the edge of the insulation bottom plate 111. When a heat change in a switching process of the diode 6 is transferred to the insulation bottom plate 111, the insulation bottom plate 111 has a sufficiently large region for heat to be evenly distributed, to improve temperature distribution balance of the insulation bottom plate 111, and reduce the risk of excessive stress concentration. Improving temperature and stress distribution balance of the insulation bottom plate 111 can reduce a risk of warping, a crack, or a fracture of the insulation bottom plate 111, and improve insulation and stability of the module, so that the power module 10 has good performance in reliability assessment.

In an embodiment, in the third direction Z, an orthographic projection of the connection block 3 on the anode 62 of the diode 6 is within a range of the anode 62. Mechanical stress is generated at a joint between the edge of the connection block 3 and the anode 62, and heat generated by the diode 6 also causes thermal stress to be generated inside the diode 6. A part of heat generated by the diode 6 during operation needs to be transferred to the top plate 12 through the anode 62 for heat dissipation. A contact area between the anode 62 and the connection block 3 and a contact position affect heat dissipation of the diode 6. If stress and temperature distribution inside the diode 6 are unbalanced, the diode 6 may have a risk of a crack or a fracture, affecting function implementation of the module.

In view of this, as shown in FIG. 10b, distribution of the diode 6 and the connection block 3 is designed for the power module 10 provided in embodiments of this application, to balance temperature and stress distribution of the diode 6 and the bottom plate 11. Specifically, in any direction perpendicular to the third direction Z, a spacing h5 between the connection block 3 and an edge of the anode 62 is 0.2 mm to 0.5 mm, so that the connection block 3 can be in contact with the anode 62 of the diode 6 in a large range, thereby ensuring high efficiency of the heat transfer channel. The spacing h5 is reserved between the connection block 3 and the edge of the anode 62, so that it can be ensured that force transferred by the connection block 3 to the diode 6 does not increase stress generated inside the diode 6. Improving temperature and stress distribution balance of the diode 6 can reduce a risk of a crack or a fracture of the diode 6, and improve stability of the module, so that the power module 10 has good performance in reliability assessment.

FIG. 11 is a top view of a partial structure of the power module 10. The power module 10 includes a plurality of power chips 2, and each power chip 2 is connected in parallel to one diode 6. In the second direction Y, the power chip 2 and a corresponding diode 6 are spaced from each other. The correspondence herein means that the diode 6 is connected in parallel to the power chip 2.

In some embodiments, in the first direction X, a plurality of power chips 2 connected in parallel are spaced from each other, and a plurality of diodes 6 corresponding to the plurality of power chips 2 are spaced from each other. The plurality of power chips 2 are electronic elements of one type, the plurality of diodes 6 are electronic elements of one type, and electronic elements of a same type are spaced from each other in the first direction X, so that the plurality of electronic elements are arranged more regularly, and a spatial layout of the module can be optimized. Regular arrangement of electronic elements can also balance temperature and stress distribution of the insulation bottom plate 111, thereby improving reliability of the module.

In an embodiment, in the second direction Y, the power chip 2 is arranged between and spaced from the corresponding diodes 6 and the edge of the first metal layer 112. It may be considered that, with the edge of the first metal layer 112 as the reference, the power chip 2 is closer to the edge of the insulation bottom plate 111 than the diode 6, to facilitate routing of the signal electrode 23 of the power chip 2. Generally, a size of the power chip 2 is greater than a size of the diode 6. The power chip 2 is disposed at a position that is on the bottom plate 11 and that is closer to the edge than the diode 6, so that a risk of edge warping of the bottom plate 11 can be reduced.

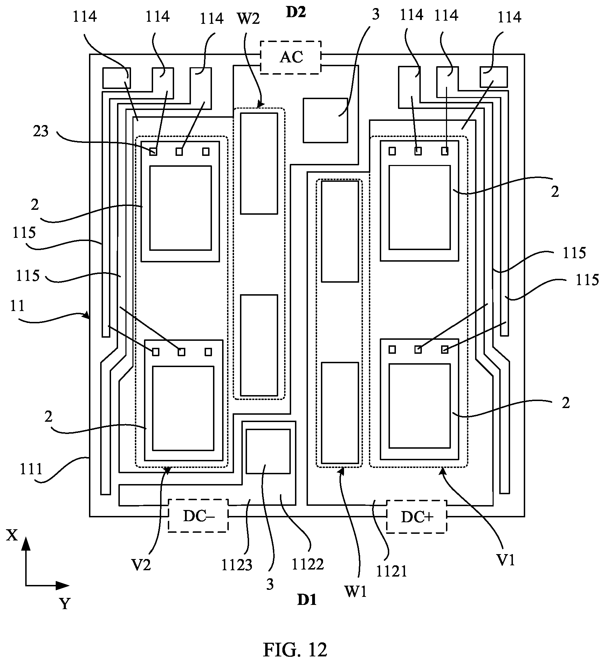

FIG. 12 is a top view of a partial structure of the power module 10. A difference from the power module 10 shown in FIG. 8 lies in that the power module 10 shown in FIG. 12 includes a plurality of diodes 6. The plurality of diodes 6 are arranged between two groups of chips in the second direction Y, that is, each diode 6 is arranged between the first group of chips V1 and the second group of chips V2 in the second direction Y.

In a structure example, the plurality of diodes 6 are divided into two groups of diodes, and one group of diodes and the other group of diodes are spaced from each other in the second direction Y. Each diode 6 in the one group of diodes is configured to be connected in parallel to one power chip 2 in one group of chips, and each diode 6 in the other group of diodes is configured to be connected in parallel to one power chip 2 in the other group of chips.

As shown in FIG. 12, the two groups of diodes 6 are a first group of diodes W1 and a second group of diodes W2, and the first group of diodes W1 and the second group of diodes W2 are spaced from each other in the second direction Y. Each diode 6 in the first group of diodes W1 is connected in parallel to one power chip 2 in the first group of chips V1, and each diode 6 in the second group of diodes W2 is connected in parallel to one power chip 2 in the second group of chips V2.

In an embodiment, one group of diodes are staggered relative to the other group of diodes in the first direction X, that is, the first group of diodes W1 and the second group of diodes W2 are arranged in a staggered manner in the first direction X. In the first direction X, a spacing between the first group of diodes W1 and the plurality of signal pads 114 is greater than a spacing between the second group of diodes W2 and the plurality of signal pads 114, and a spacing between the first group of diodes W1 and the end that is of the insulation bottom plate 111 and that is away from the plurality of signal pads 114 is less than a spacing between the second group of diodes W2 and the end that is of the insulation bottom plate 111 and that is away from the plurality of signal pads 114. The first terminal side D1 and the second terminal side D2 of the bottom plate 11 are used as a reference, a spacing between the first group of diodes W1 and the second terminal side D2 is greater than a spacing between the second group of diodes W2 and the plurality of second terminal sides D2, and a spacing between the first group of diodes W1 and the first terminal side D1 is less than a spacing between the second group of diodes W2 and the first terminal side D1.

Based on arrangement of the two groups of diodes 6, a structure layout of the bottom plate 11 may be further optimized. As shown in FIG. 12, in the second direction Y, one connection block 3 is arranged between the first group of diodes W1 and the second group of chips V2, and the connection block 3 is configured to connect the third metal sublayer 1123 to the top plate 12. One connection block 3 is disposed between the second group of diodes W2 and the first group of chips V1, and the connection block 3 is configured to connect the second metal sublayer 1122 to the top plate 12. The two connection blocks 3 may be arranged by using vacant positions of the two groups of diodes in the first direction X and the second direction Y, and do not occupy larger space of the bottom plate 11. This helps implement module miniaturization. The first group of diodes W1 and the second group of diodes W2 are arranged in a staggered manner in the first direction X, so that the two connection blocks 3 are distributed on two sides of the bottom plate 11 relative to each other in the first direction X. This can balance force applied to the bottom plate 11, and enhance reliability of the bottom plate 11.

It should be understood that, based on the foregoing structure layout of the plurality of power chips 2, the plurality of diodes 6, and the two connection blocks 3, relative positions and shapes of different metal sublayers of the first metal layer 112 are adjusted, to meet a circuit connection requirement. Details are not described herein again. According to the power module 10 provided in embodiments of this application, a layout of the bottom plate 11 and the electronic element is adjusted, to balance temperature and stress distribution of the insulation bottom plate 111, so that a risk of a crack caused by stress concentration on the insulation bottom plate 111 can be reduced. A layout of the electronic element and the connection block 3 is adjusted to balance temperature and stress distribution of the electronic element, so that a risk of a crack in the electronic element can be reduced, and heat dissipation effect of each electronic element can be optimized.

The power module may be applied to, for example, an on-board microcontroller unit (microcontroller unit, MCU) or an on-board battery charger (on-board battery charger, OBC) of an electric vehicle, or may be applied to another power conversion device.

In the field of consumer electronics, the power module 10 may be used in a device like a power adapter, an inverter, or a frequency converter. The power adapter is a power supply conversion device for a small portable electronic device and an electronic and electrical appliance. The power module is configured to convert electric energy and amplify power, and can convert an alternating current into a direct current to provide a stable and reliable power supply for the device, so as to ensure that the device can operate normally. The inverter is a power electronic apparatus including a semiconductor power chip. The power module can convert a direct current into an alternating current, and can implement efficient electric energy conversion in the inverter, to provide power support for places such as a home and an office.

In the power energy field, the power module 10 may be used in a device such as a solar inverter or a wind power generation converter. The solar inverter can convert a direct current generated by a solar panel into an alternating current and send the alternating current to a power grid. The power module is responsible for implementing efficient electric energy conversion and reliable power grid access, to provide power support for a home, an enterprise, and the like. The wind power generation converter is a device configured to control a rotational speed of a generator, adjust output power, and ensure stable running of a power grid in a wind power generation system. A power module can adjust a rotational speed and an output power of the generator based on a wind speed and a load change, to convert and control electric energy, ensure the safe and stable operation of the wind power system.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A power module, wherein the power module comprises a bottom plate and a plurality of power chips;
the bottom plate comprises an insulation bottom plate, a first metal layer, a plurality of signal pads, and a plurality of routing layers, the first metal layer, the plurality of signal pads, and the plurality of routing layers are all disposed on a surface of the insulation bottom plate, the plurality of power chips are disposed on the first metal layer, the plurality of power chips and the plurality of signal pads are spaced from each other in a first direction, a gate signal electrode of each power chip is connected to one signal pad or one routing layer, a power signal electrode of each power chip is connected to one signal pad or one routing layer, and the signal pad is configured to connect to a signal terminal;
a first end of each routing layer is connected to one signal pad, a second end extends to be arranged, in a second direction, between an edge of the first metal layer and an edge of the insulation bottom plate, and widths of the plurality of routing layers are less than a width of the first metal layer in the second direction; and
both the first direction and the second direction are perpendicular to a thickness direction of the power module, and the first direction is perpendicular to the second direction.

2. The power module according to claim 1, wherein the plurality of power chips comprise a first chip and a second chip, and the first chip is arranged between and spaced from the plurality of signal pads and the second chip in the first direction;
a power signal electrode of the first chip is connected to one signal pad, and a gate signal electrode of the first chip is connected to another signal pad; and
a power signal electrode of the second chip is connected to one routing layer, and a gate signal electrode of the second chip is connected to another routing layer.

3. The power module according to claim 2, wherein the first chip and the second chip are connected in parallel;
the one signal pad connected to the power signal electrode of the first chip is connected to the one routing layer connected to the power signal electrode of the second chip; and
the another signal pad connected to the gate signal electrode of the first chip is connected to the another routing layer connected to the gate signal electrode of the second chip.

4. The power module according to claim 2 or 3, wherein the plurality of routing layers comprise a first routing layer and a second routing layer; and
in the second direction, a part of the first routing layer and a part of the second routing layer are adjacently arranged between the first chip and the edge of the insulation bottom plate, and the part of the first routing layer is arranged between the first chip and the part of the second routing layer.

5. The power module according to claim 4, wherein in the second direction, the power signal electrode of the second chip is arranged between the gate signal electrode of the second chip and the first routing layer, the power signal electrode of the second chip is connected to the second routing layer, and the gate signal electrode of the second chip is connected to the first routing layer.

6. The power module according to claim 5, wherein in the first direction, a connection position between the gate signal electrode of the second chip and the first routing layer is located between the first chip and the second chip, and a connection position between the power signal electrode of the second chip and the second routing layer is located between the first chip and the second chip.

7. The power module according to claim 5 or 6, wherein in the first direction, the connection position between the power signal electrode of the second chip and the second routing layer is located on a side that is of the connection position between the gate signal electrode of the second chip and the first routing layer and that is away from the plurality of signal pads.

8. The power module according to any one of claims 2 to 7, wherein the plurality of routing layers comprise a first routing layer and a second routing layer; and
in the first direction, a length of the first routing layer is greater than a length of the second routing layer.

9. The power module according to claim 8, wherein in the first direction, a spacing between the first routing layer and an end that is of the insulation bottom plate and that is away from the plurality of signal pads is less than a spacing between the second chip and the end that is of the insulation bottom plate and that is away from the plurality of signal pads.

10. The power module according to claim 8 or 9, wherein a spacing between the second routing layer and the end that is of the insulation bottom plate and that is away from the plurality of signal pads is less than a spacing between the first chip and the end that is of the insulation bottom plate and that is away from the plurality of signal pads.

11. The power module according to any one of claims 4 to 10, wherein the plurality of power chips comprise two groups of chips, one group of chips and the other group of chips are spaced from each other in the second direction, and each group of chips comprises the first chip and the second chip;
the plurality of routing layers comprise two groups of routing layers, and each group of routing layers comprises the first routing layer and the second routing layer; and
the two groups of routing layers are respectively arranged on two sides of the first metal layer in the second direction, the power signal electrode of the second chip in each group of chips is connected to a second routing layer in one adjacent group of routing layers, and the gate signal electrode of the second chip in each group of chips is connected to a first routing layer in one adjacent group of routing layers.

12. The power module according to claim 11, wherein the power module further comprises a plurality of diodes, the plurality of diodes are disposed between the two groups of chips in the second direction, and each diode is connected in parallel to one power chip.

13. The power module according to claim 12, wherein the plurality of diodes comprise two groups of diodes, one group of diodes and the other group of diodes are spaced from each other in the second direction, and one group of diodes is staggered relative to the other group of diodes in the first direction; and
each diode in one group of diodes is configured to be connected in parallel to one power chip in one group of chips, and each diode in the other group of diodes is configured to be connected in parallel to one power chip in the other group of chips.

14. The power module according to any one of claims 1 to 13, wherein the power module further comprises a top plate and a plurality of connection blocks;
in a direction perpendicular to the bottom plate, the top plate is disposed on a side that is of the plurality of power chips and that faces away from the bottom plate; and
each power chip further comprises a second electrode, both the second electrode and the signal electrodes are disposed on a surface that is of the power chip and that faces away from the bottom plate, the second electrode is connected to the top plate via one or more connection blocks, and the signal electrodes are spaced from each other in the first direction on a side that is of the second electrode and that faces the signal pad.

15. A power conversion device, wherein the power conversion device comprises at least one power module according to any one of claims 1 to 14, and each power module is configured to convert a direct current into an alternating current or convert a direct current into an alternating current.
